# EUROPEAN PATENT APPLICATION

(11) **EP 4 769 003 A1**
(43) Date of publication of application: **01.07.2026**
(21) Application number: 25226603.6
(22) Date of filing: 22.12.2025
(51) Int. Cl.: G02B 23/18, G02B 7/12, G02B 7/06, G01R 33/07, G02B 23/12, H04N 23/65

(54) **AUTOMATIC POWER-ON/OFF STRUCTURE FOR ROTATION-AND-FLIP OPERATIONS OF NIGHT-VISION DEVICE**

(30) Priority: 26.12.2024 CN 202423238459 U
(71) Applicant: Ningbo ShiYe Technology Co., Ltd., Ningbo City, Zhejiang 315502 (CN)
(72) Inventor: TONG, Yifeng, Ningbo City, 315502 (CN)
(74) Representative: Valet Patent Services Limited

(57) **Abstract**

An automatic power-on/off structure for rotation-and-flip operations of a night-vision device is provided, relating to the technical field of night-vision devices. The structure includes a frame, two pivot arms, two night-vision scopes, two magnets, and two Hall sensors. Through the interaction between the magnets and the Hall sensors, i.e., a non-rigid contact, the structure enables automatic powering on of a night-vision scope when in use and automatic powering off when not in use. Specifically, when a pivot arm drives the corresponding night-vision scope to rotate to a certain angle, the magnet enters the sensing range of the Hall sensor, thereby triggering a signal to power on that night-vision scope. Conversely, when the pivot arm drives the night-vision scope away from the sensing range, that scope is automatically powered off. In addition, the pivot shaft connecting the pivot arm and the frame includes an adjustable damping feature, and sealing rings are provided at the contact portions to ensure dustproof and waterproof performance, allowing the structure to adapt to a wide range of operating conditions.

## Description

### TECHNICAL FIELD

The present disclosure relates to the technical field of night-vision devices, and in particular to an automatic power-on/off structure for rotation-and-flip operations of a night-vision device.

### BACKGROUND

Night-vision devices that rely on image intensifier tubes operate by receiving light through an objective lens, and performing photoelectric conversion of starlight by a low-light image intensifier tube to amplify the existing light, that is, low-light by virtue of an avalanche effect. Such devices are widely used in military, law-enforcement, and outdoor applications for observation tasks performed at night or in low-light conditions. In this subdivided field, a binocular night-vision device with dual objective lenses (referred to as a binocular night-vision device) includes two independent objective lenses and two independent eyepieces, and employs two separate image intensifier tubes, thereby providing improved overall performance such as enhanced visual effect and depth perception, and is more broadly used in specialized applications including special-operations missions, high-speed driving, and aircraft piloting activities.

Two major types of existing binocular night-vision devices are commonly available. One type includes two optical barrels that are completely fixed and cannot be flipped laterally. The other type has a structure similar to a telescope and allows the optical barrels to be flipped laterally. Binocular night-vision devices with dual objective lenses and image intensifier tubes are limited in practicality due to their size, and, in actual use, the binocular configuration prevents the user from observing in normal-light conditions with the other unaided eye, as is possible when using a monocular night-vision device. A binocular night-vision device with laterally flippable optical barrels can address this issue. However, in currently available devices with laterally flippable barrels, the flipped barrel typically remains powered, because in common assembly and design practices for binocular night-vision devices, the wire harness is introduced into each barrel through the pivot shaft and directly connected to the intensifier. The user is not allowed to individually power off the intensifier on one side, and can only power off both intensifiers simultaneously through the main power switch.

In actual use, particularly in special-operations missions or low-light law-enforcement scenarios, the operator of a binocular night-vision device often cannot determine in advance whether the indoor or outdoor conditions is dim or bright. The operator therefore needs to keep one laterally flippable barrel of the binocular night-vision device positioned at the eye while flipping up the other barrel, allowing one eye to retain low-light vision through the night-vision device and the other eye to retain natural-light vision. However, with existing structures and solutions, even if one or both barrels can be flipped laterally either independently or simultaneously, the flipped-up barrel continues to receive power. If the ambient light at that moment is excessively bright, there is a risk of damaging the image intensifier tube. Conversely, if the main power switch is turned off, the purpose of wearing the night-vision device is defeated entirely, as both eyes lose low-light observation capability. If the operator then enters dimly lit conditions and must reactivate the power, the delay may compromise mission effectiveness and may even result in personnel casualties.

In actual use, laterally flipping the binocular night-vision device away from the user eyes rather than folding the device upward toward the top of a helmet offers various additional advantages, such as more effectively reducing impacts and collisions. However, with existing solutions, after laterally flipping the optical barrel, the user must manually turn off the power, and when the night-vision device is needed again, the user must first turn on the power and then flip the barrel back down. This consumes substantial time and may critically delay mission response.

This means that, for a binocular night-vision device with laterally flippable barrels, it is highly important for the image intensifier within the barrel to automatically power off when the barrel is flipped away from the field of view, and to automatically power on when the barrel is flipped back down into the field of view.

One existing solution is an automatic power-on/off pivot structure invented by the same inventor, which relies on hard contact between electrical contacts and a metallic contact piece (Patent Nos. ZL202020227194.X and ZL202010129207.4). Although this solution is highly effective, it may suffer from potential structural failure after long-term use, such as breakage of the electrical contacts leading to malfunction of the pivot power-supply structure. After repeated long-term operation, the protruding contact may also abrade the non-metallic portion inside the pivot structure through repeated friction, causing wear that may allow the contact to spontaneously pop out at the worn area and potentially become stuck upon encountering a metallic conductive component.

### SUMMARY

To this end, the present disclosure provides an automatic power-on/off structure for rotation-and-flip operations of a night-vision device.

To achieve the above objective, the present disclosure provides the following technical solution. An automatic power-on/off structure for rotation-and-flip operations of a night-vision device includes a frame, two pivot arms, two night-vision scopes, two magnets, and two Hall sensors. The two pivot arms are respectively connected to opposite sides of the frame via pivot shafts. The night-vision scopes are mounted on the lower portions of the pivot arms. The Hall sensors are provided on the frame, and the magnets are mounted on the top portions of the pivot arms. The magnets and respective Hall sensors form a non-rigid contact structure to control the powering on and off of the night-vision scopes.

Further, the device frame includes a device body, and the two Hall sensors are symmetrically mounted inside the device body.

Further, the top portions of the pivot arms are provided with reserved slots, and the magnets are fixed inside the reserved slots, respectively.

Further, the sensing range of the Hall sensors is sector-shaped with an angle of 30°.

Further, as the pivot arm drives the night-vision scope to rotate such that the magnet enters the sector-shaped sensing range of the Hall sensor, the Hall sensor transmits a signal to automatically power on the night-vision scope.

Further, as the pivot arm drives the night-vision scope to rotate such that the magnet leaves the sector-shaped sensing range of the Hall sensor, the Hall sensor transmits a signal to automatically power off the night-vision scope.

Further, the pivot shaft connecting the frame and the pivot arm has an adjustable damping feature.

Further, the contact positions of the pivot shaft with the frame and the pivot arms are each provided with sealing rings to ensure dust-proof and waterproof performance.

The present disclosure offers the following advantageous effects compared with the prior art.
1. The automatic power-on/off structure for rotation-and-flip operations of the night-vision device can automatically power on and off the binocular night-vision barrels during lateral flipping by virtue of a non-rigid contact structure between the Hall sensors and the magnets. This innovative design not only retains the advantages of binocular night-vision devices in specialized applications such as special operations and high-speed driving, but also significantly enhances practicality and flexibility, enabling operators or users to switch observation modes more freely in complex lighting conditions.
2. With the automatic power-on/off structure, the user can operate one side of the night-vision device while maintaining natural-light vision in the other eye, thereby improving operational efficiency and safety. Moreover, the automatic power-on/off function eliminates delays caused by manual operation, ensuring that operators can respond rapidly.
3. Compared with folding the night-vision device upward toward the top of a helmet, the lateral flipping of the night-vision barrels of the automatic power-on/off structure effectively reduces the risk of impacts and other accidental damage.
4. Compared with automatic power-on/off structures that rely on hard contact between electrical contacts and metallic contact pieces, the present disclosure employs a non-rigid contact between Hall sensors and magnets, avoiding failures caused by contact breakage or wear after long-term use. This improvement not only enhances structural stability and reliability but also reduces maintenance difficulty and cost.
5. The automatic power-on/off of the night-vision barrels allows the binocular night-vision device in the present disclosure to be applied in a wider range of scenarios. Whether in adverse conditions such as rain or dust, or in situations requiring rapid switching between observation modes, this technical solution can offer excellent performance and reliability.

### BRIEF DESCRIPTION OF DRAWINGS

In order to further clearly illustrate the embodiments of the present disclosure or the technical solutions in the prior art, the drawings used in the description of the embodiments or the prior art will be briefly described below. It is apparent that the drawings in the following description are only exemplary, from which those of ordinary skill in the art can derive drawings of other embodiments without any creative work.

The structures, proportions, dimensions, and the like illustrated in the present specification are provided solely to assist those of ordinary skill in the art in understanding and reading the disclosure, and are not intended to limit the conditions under which the present disclosure may be implemented. Accordingly, they do not carry substantive technical significance. Any modifications to the structures, changes to proportional relationships, or adjustments to dimensions, so long as they do not affect the efficacy or the objectives achievable by the present disclosure, shall fall within the scope of the technical content disclosed herein.
Fig. 1 is an exploded perspective view of a first embodiment of the present disclosure.
Fig. 2 is an assembled perspective view of the first embodiment of the present disclosure.
Fig. 3 is a perspective view showing a Hall sensor mounted inside the frame body in the first embodiment of the present disclosure.
Fig. 4 is an exploded perspective view of a magnet and a pivot arm in the first embodiment of the present disclosure.
Fig. 5 is a sectional view showing the first embodiment of the present disclosure in a powered-on state.
Fig. 6 is a sectional view showing the first embodiment of the present disclosure in a powered-off state.
Fig. 7 is an exploded perspective view showing the frame in the second embodiment of the present disclosure.
Fig. 8 is a perspective view showing a battery compartment inside a front cover in the second embodiment of the present disclosure.
Fig. 9 is an exploded perspective view of a fill light in a third embodiment of the present disclosure.
Fig. 10 is a perspective view of a cap in the third embodiment of the present disclosure.
Fig. 11 is a perspective view of a mounting connector in a fourth embodiment of the present disclosure.
Fig. 12 is a top view of the mounting connector in the fourth embodiment of the present disclosure.
Fig. 13 is a bottom view of the mounting connector in the fourth embodiment of the present disclosure.
Fig. 14 is a perspective view of an objective lens cover from a first viewing angle in a fifth embodiment of the present disclosure.
Fig. 15 is a perspective view of the objective lens cover from a second viewing angle in the fifth embodiment of the present disclosure.

In the drawings:

| | | | | | |
|---|---|---|---|---|---|
| 1 | frame; | 11 | device body; | 111 | Hall sensor; |
| 12 | front cover; | 121 | first reserved hole; | 122 | second reserved hole; |
| 123 | fill light; | 124 | photosensitive sensor; | 125 | cap; |
| 126 | lens; | 13 | rear cover; | 14 | battery compartment; |
| 15 | battery compartment cover; | | | 16 | handle; |
| 17 | short screw; | 18 | long screw; | 2 | pivot arm; |
| 21 | reserved slot; | 22 | magnet; | 3 | night-vision scope; |
| 31 | objective lens; | 32 | eyepiece; | 4 | mounting connector; |
| 41 | main body; | 42 | first weight-reduction groove; | 421 | rounded corner; |
| 43 | second weight-reduction groove; | 44 | multifunctional reserved hole; | | |
| 45 | stepped groove; | 46 | protrusion; | 47 | jack; |
| 48 | first weight-reduction inclined surface; | 49 | second weight-reduction inclined surface; | | |
| 5 | objective lens cover; | 51 | end cap; | 52 | snap ring; |
| 53 | bracket; | 54 | through hole; | 55 | light-reduction lens; |
| 56 | anti-slip groove; and | 57 | snap slot. | | |

### DETAILED DESCRIPTION OF EMBODIMENTS

The following specific embodiments illustrate implementations of the present disclosure. Those of ordinary skill in the art can readily understand other advantages and effects of the present disclosure based on the contents disclosed herein. It should be noted that the embodiments described are merely part of the embodiments of the present disclosure rather than all embodiments. All other embodiments obtained by those of ordinary skill in the art based on the embodiments of the present disclosure without inventive effort shall fall within the scope sought to be protected by the present disclosure.

### First Embodiment

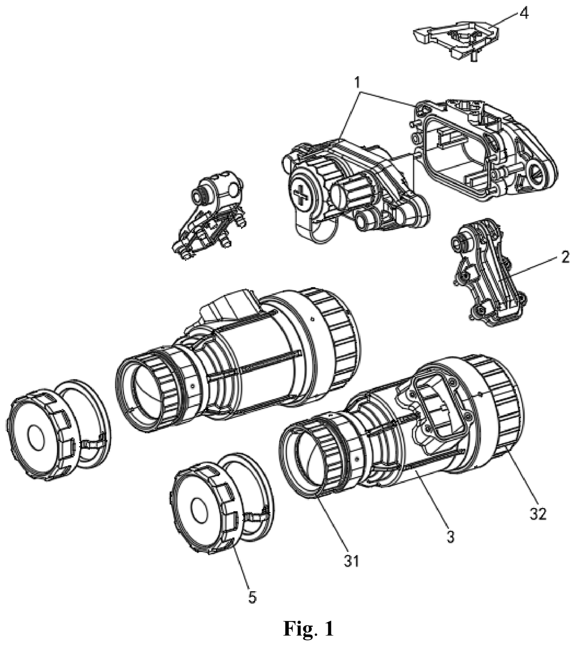

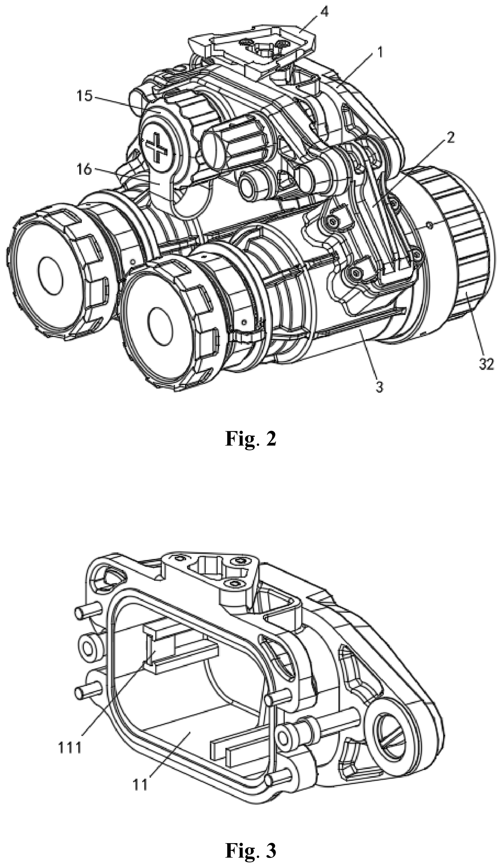

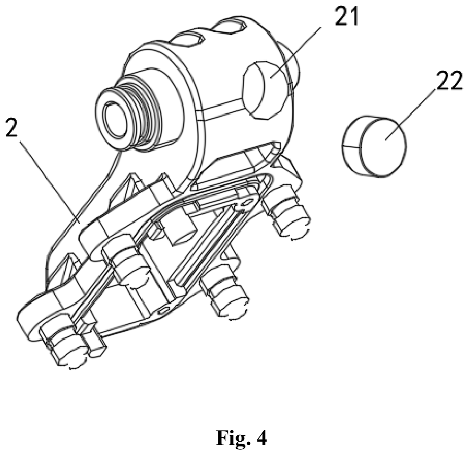

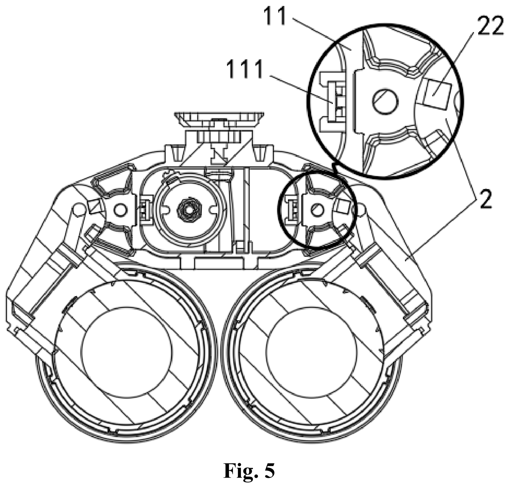

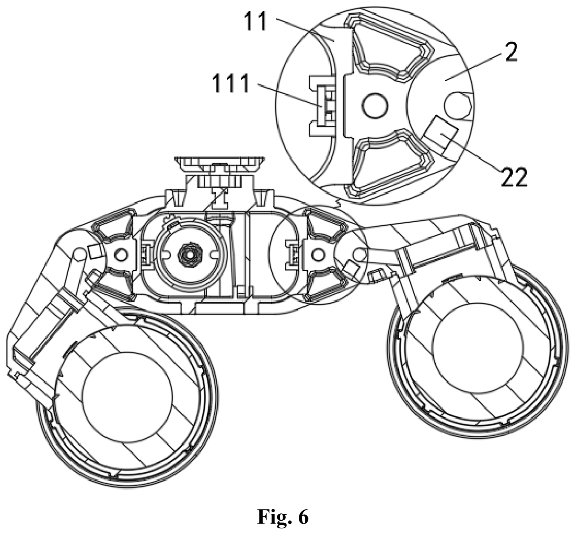

As shown in Fig. 1 to Fig. 6, the automatic power-on/off structure for rotation-and-flip operations of a night-vision device mainly includes a frame 1, two pivot arms 2, two night-vision scopes 3, two magnets 22, and two Hall sensors 111. The two pivot arms 2 are respectively connected to opposite sides of the frame 1 via pivot shafts. The two night-vision scopes 3 are respectively mounted on lower portions of the two pivot arms 2. The two magnets 22 are embedded in upper portions of the pivot arms 2, respectively. The frame 1 includes a frame body 11, and the two Hall sensors 111 are symmetrically mounted inside the device body 11. The magnet 22 and the Hall sensor 111 jointly form a non-rigid contact structure. By virtue of this non-rigid contact structure, when either pivot arm 2 drives its corresponding night-vision scope 3 to rotate, the power supplied to that night-vision scope 3 is automatically switched off or on.

A reserved slot 21 is formed at the top of the pivot arm 2, and the magnet 22 is secured inside the reserved slot 21, such that the magnet 22 does not protrude from the top of the pivot arm 2 and therefore does not interfere with the pivoting movement of the pivot arm 2.

The pivot shaft connecting the device frame 1 and the pivot arm 2 is a pivot shaft with an adjustable damping force. Sealing rings are provided at the contact portions between the pivot shaft and the device frame 1, as well as between the pivot shaft and the pivot arm 2, ensuring that the rotating portions between the frame 1, the pivot arm 2, and the pivot shaft remain dustproof and waterproof. This enhances the suitability of the night-vision device for various operating conditions, such as use in rainy or humid conditions or in conditions with significant dust.

In this embodiment, during use, the Hall sensor 111 and the magnet 22 form a non-rigid contact structure. The sensing range of the Hall sensor 111 is sector-shaped and has an angle of approximately 30°. The specific process for power-on and power-off is as follows.

When the night-vision scope 3 and the pivot arm 2 rotate downward toward the user eye to a certain angle, the magnet 22 enters the 30° sector sensing range of the Hall sensor 111. At this moment, the Hall sensor 111 sends a signal to the circuitry inside the device frame 1, causing this night-vision scope 3 to automatically power on. Conversely, when the night-vision scope 3 and the pivot arm 2 rotate upward away from the user eye, once the magnet 22 exits the 30° sector sensing range of the Hall sensor 111, the Hall sensor 111 can no longer detect the magnetic field generated by the magnet 22. The absence of the magnetic field is transmitted to the circuitry, causing this night-vision scope 3 to automatically power off. In this way, the night-vision scope 3 can be automatically powered on when in use and can be automatically powered off when not in use.

### Second Embodiment

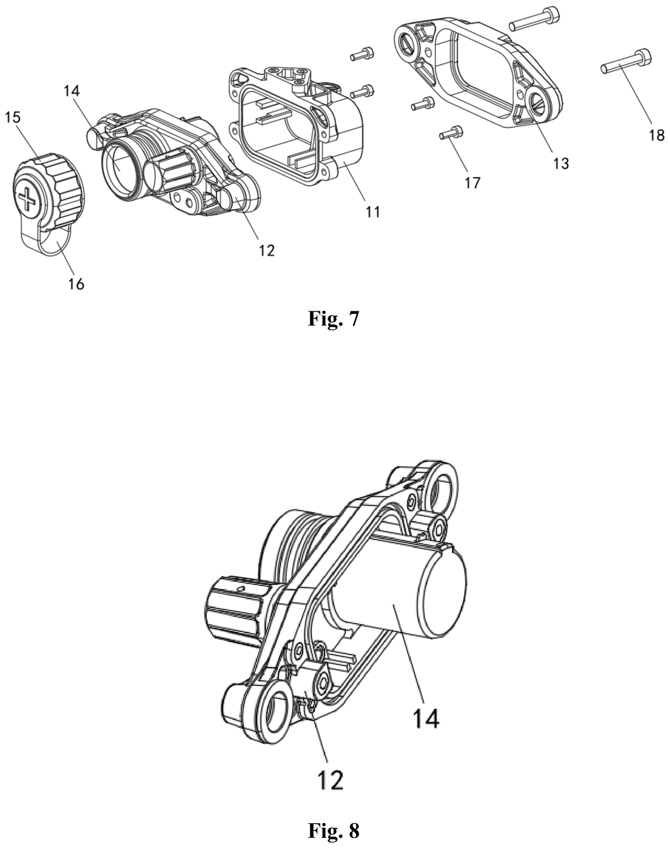

As shown in Figs. 7 to 8, in the automatic power-on/off structure for rotation-and-flip operations of the night-vision device, the frame 1 mainly includes a frame body 11, a front cover 12, and a rear cover 13. The front cover 12 and the rear cover 13 are mounted on both sides of the frame body 11 by bolts. That is, when the front cover 12 and the rear cover 13 are installed, they provide protection for the frame body 11, and when removed, the frame body can be replaced. In addition, a battery compartment 14 is fixedly mounted inside the front cover 12. The battery compartment 14 is oriented perpendicular to the front cover 12, and a tail end of the battery compartment 14 extends into the interior of the frame body 11. By reasonably arranging the position of the battery compartment 14, the overall size of the binocular night-vision device is significantly reduced, while also reducing the installation space occupied by the battery compartment 14 itself.

A cavity is reserved inside the frame body 11, and the tail end of the battery compartment 14 is located within this cavity. The port of the battery compartment 14 is threadedly connected to a battery compartment cover 15, and the exterior of the battery compartment cover 15 is rotatably connected to a handle 16.

The bolts include long screws 18 and short screws 17. The frame body 11 is fixedly connected to the front cover 12 by several short screws 17, and the frame body 11 is fixedly connected to the rear cover 13 by several long screws 18.

### Third Embodiment

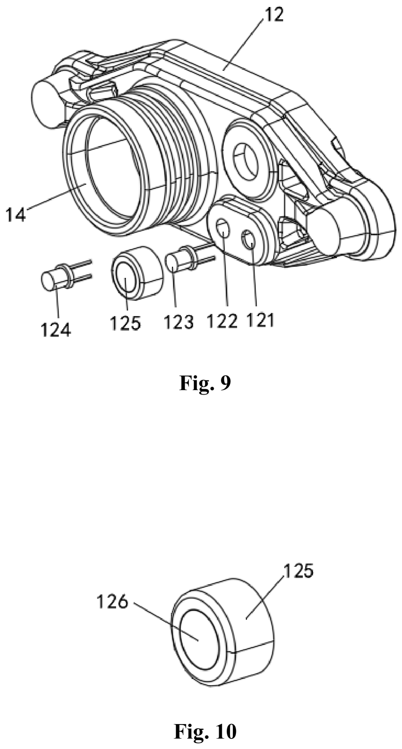

As shown in Figs. 1, 9 and 10, in the automatic power-on/off structure for rotation-and-flip operations of the night-vision device, the front cover 12 of the present disclosure, the fill light 123, the photosensitive sensor 124, and the cap 125 are the main components. The fill light 123 and the photosensitive sensor 124 are both embedded at the bottom of the front cover 12. The exterior of the fill light 123 is secured with the cap 125 threadedly connected to the front cover 12. Inside the end of the cap 125 opposite to the front cover 12, a lens 126 is mounted, which may be a convex or concave lens. Depending on different light sources and scenarios, caps 125 with different lenses 126 can be selected for use, thereby improving the adaptability of the binocular night-vision device to various conditions and ensuring that the fill light 123 provides stable and continuous illumination. The outer end of the cap 125 protrudes from the handle 16, and this protrusion effectively prevents the handle of the battery compartment cover from blocking the light emitted by the fill light 123 during use. This protrusion not only offers a clever utilization of space but also significantly enhances the convenience and reliability of using the fill light in practical operation.

In addition, at the bottom of the front cover 12, a first reserved hole 121 and a second reserved hole 122 are provided. The fill light 123 and the photosensitive sensor 124 are respectively mounted within the first reserved hole 121 and the second reserved hole 122. That is, the fill light 123 and the photosensitive sensor 124 are concealed within the front cover 12, thereby preventing damage to the fill light 123 and the photosensitive sensor 124 caused by external impacts or other ambient factors.

The interior of the front cover 12 is further provided with a battery compartment 14, the port of the battery compartment 14 is threadedly connected to a battery compartment cover 15. The end of the battery compartment cover 15 is movably connected to a handle 16. At least one night-vision scope 3 is mounted at the lower portion of the front cover 12, with an objective lens 31 at one end and an eyepiece 32 at the other end. It should be noted that the fill light 123, the photosensitive sensor 124, and the cap 125 are all disposed on the same side as the objective lens 31, thereby facilitating supplemental illumination of the external conditions and sensing of ambient light conditions.

### Fourth Embodiment

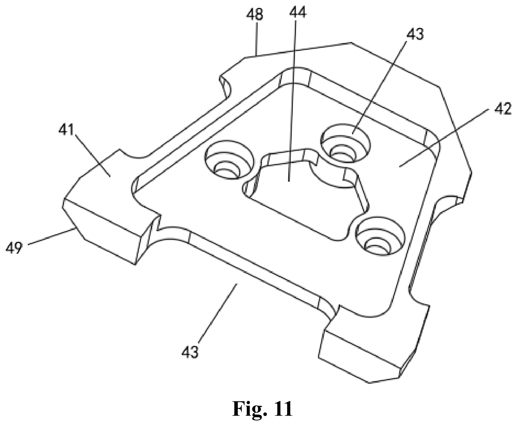

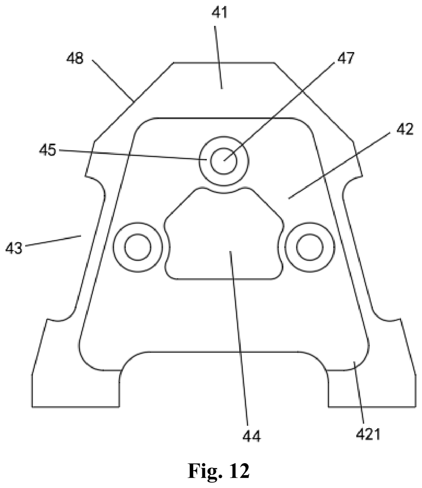

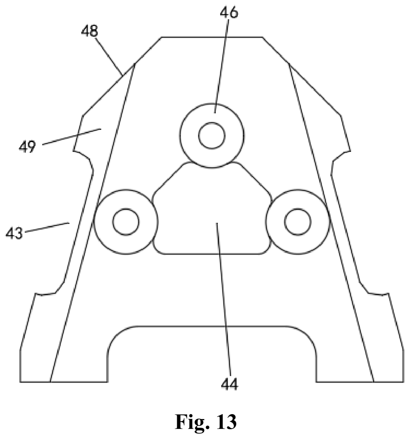

As shown in Figs. 11 to 13, in the automatic power-on/off structure for rotation-and-flip operations of the night-vision device, the upper portion of the frame 1 is mounted with a mounting connector 4 by several bolts. The mounting connector 4 includes a main body 41, with a first weight-reduction groove 42 reserved at the upper portion of the main body 41. Rounded corners 421 are provided at the corners of the first weight-reduction groove 42. Several second weight-reduction grooves 43 are reserved along the edges of the main body 41. A multifunctional reserved hole 44 is provided inside the main body portion 41, which is in communication with the first weight-reduction groove 42. The multifunctional reserved hole 44 not only serves a weight-reduction purpose but also functions as a gas-filling clearance hole. A through-hole for nitrogen filling is provided at the top of the binocular night-vision device, and the multifunctional reserved hole 44 exposes the nitrogen through-hole to facilitate nitrogen injection, thereby enhancing the practicality and flexibility of the connector and meeting the requirements of different application scenarios. Several bolt mounting positions are reserved inside the main body 41 around the multifunctional reserved hole 44. The end of the main body 41 is symmetrically provided with first weight-reduction inclined surfaces 48, and the bottom portions on both sides of the main body 41 are provided with second weight-reduction inclined surfaces 49. The angles of the first and second weight-reduction inclined surfaces 48, 49 are both set to 45°.

Through the provision of the first weight-reduction groove 42, several second weight-reduction grooves 43, the multifunctional reserved hole 44, multiple bolt mounting positions, the first weight-reduction inclined surfaces 48, and the second weight-reduction inclined surfaces 49, the overall weight of the main body 41 can be significantly reduced. This not only alleviates the burden on the wearer but also enhances comfort during prolonged use, preventing neck and head fatigue caused by excessive weight.

The bolt mounting positions are formed by a stepped groove 45 reserved at the bottom of the first weight-reduction groove 42, a protrusion 46 integrally connected to the bottom of the main body 41, and a jack 47 jointly defined by the main body 41 and the stepped groove 45. The stepped groove 45 is in communication with the jack 47. The provision of the stepped groove 45 allows the screw heads to be concealed, preventing protrusion. By inserting screws into the bolt mounting positions, the mounting connector can be securely installed onto the binocular night-vision device.

### Fifth Embodiment

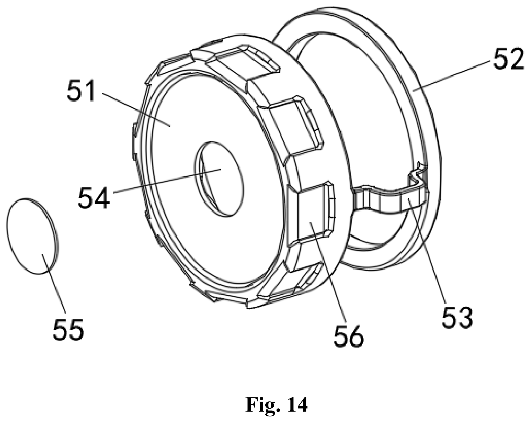

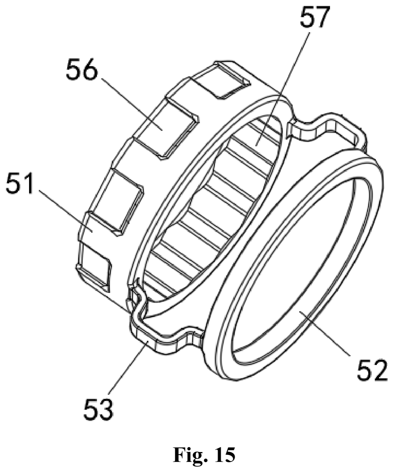

As shown in Figs. 1, 14 and 15, in the automatic power-on/off structure for rotation-and-flip operations of the night-vision device according to the present disclosure, the main components include the frame 1, the night-vision scope 3, and the objective lens cover 5. The number of night-vision scope 3 is at least one, and each night-vision scope 3 is rotatably connected to the lower portion of the frame 1, with an objective lens 31 at one end and an eyepiece 32 at the other end. The objective lens cover 5 is snap-fitted over the objective lens 31. A light-reduction lens 55 is mounted inside the objective lens cover 5, which protects the objective lens 31 while not affecting external testing for the objective lens 31. The light-reduction lens 55 also allows direct observation of the internal condition of the objective lens 31.

Specifically, the objective lens cover 5 comprises an end cap 51, a snap ring 52, a bracket 53, a through hole 54, and a light reduction lens 55. The end cap 51 is sleeved over the exterior of the objective lens 31. Several anti-slip grooves 56 are provided around the outer surface of the end cap 51, and several snap slots 57 are provided around the inner surface of the end cap 51. The snap slots 57 are configured to correspond with the groove structure formed on the outer surface of the objective lens 31, thereby snap-fitting the end cap 51 to the objective lens 31. The snap ring 52 is snap-fitted to the exterior of the night-vision scope 3. The bracket 53 is connected between the end cap 51 and the snap ring 52, and is shaped in a " 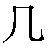 " configuration to avoid the protrusion of the objective lens 31. The through hole 54 is reserved in the central portion of the end cap 51, and the light-reduction lens 55 is mounted inside the through hole 54.

When the binocular night-vision device is not in use, the objective lens cover 5 is sleeved over the outside of the objective lens 31. The through hole 54 prevents strong light from damaging the objective lens 31. In addition, by virtue of the through hole 54, testing of the objective lens 31 can be performed without removing the objective lens cover 5. The internal conditions of the objective lens 31 can also be directly observed through the through hole 54.

Although the present disclosure has been described in detail above by way of general description and specific embodiments, various modifications or improvements may be made based on the present disclosure, which would be apparent to those skilled in the art. Accordingly, any such modifications or improvements made without departing from the spirit of the present disclosure fall within the scope sought to be protected.

The terms "upper," "lower," "left," "right," "middle," and the like as referenced in the present specification are merely for ease of description and are not intended to limit the scope of the present disclosure. Any changes or adjustments to such relative orientations, without substantive changes to the technical content, shall also be regarded as falling within the scope in which the present disclosure may be practiced.

## Claims

1. An automatic power-on/off structure for rotation-and-flip operations of a night-vision device, comprising:
a frame (1);
two pivot arms (2);
two night-vision scopes (3);
two magnets (22); and
two Hall sensors (111), wherein the two pivot arms (2) are connected to respective sides of the frame (1) through pivot shafts, the night-vision scopes (3) are mounted on lower portions of the respective pivot arms (2), the Hall sensors (111) are arranged on the frame (1), and the magnets (22) are mounted on upper portions of the pivot arms (2), the magnets (22) and the Hall sensors (111) forming a non-rigid contact configured to control powering on and powering off of the night-vision scopes (3).

2. The automatic power-on/off structure for rotation-and-flip operations of a night-vision device according to claim 1, wherein the frame (1) comprises a frame body (11), and the two Hall sensors (111) are symmetrically mounted inside the frame body (11).

3. The automatic power-on/off structure for rotation-and-flip operations of a night-vision device according to claim 1, wherein reserved slots (21) are provided at the upper portions of the pivot arms (2), and the magnets (22) are fixed within the reserved slots (21), respectively.

4. The automatic power-on/off structure for rotation-and-flip operations of a night-vision device according to claim 1, wherein a sensing range of each of the two Hall sensors (111) is sector-shaped with an angle of 30°.

5. The automatic power-on/off structure for rotation-and-flip operations of a night-vision device according to claim 1, wherein each of the two Hall sensors (111) is configured to transmit a signal to automatically power on the cprresponding night-vision scope (3) as the cprresponding pivot arm (2) drives the night-vision scope (3) to rotate such that the magnet (22) enters a sector-shaped sensing range of that Hall sensor (111).

6. The automatic power-on/off structure for rotation-and-flip operations of a night-vision device according to claim 1, wherein each of the two Hall sensors (111) is configred to transmit a signal to automatically power off the corresponding night-vision scope (3) as the corresponding pivot arm (2) drives the night-vision scope (3) to rotate such that the magnet (22) leaves a sector-shaped sensing range of that Hall sensor (111).

7. The automatic power-on/off structure for rotation-and-flip operations of a night-vision device according to claim 1, wherein the pivot shafts connecting the frame (1) and the pivot arms (2) have an adjustable damping feature.

8. The automatic power-on/off structure for rotation-and-flip operations of a night-vision device according to claim 1 or 7, wherein sealing rings are provided at contact positions between the pivot shafts and the frame (1) and between the pivot shafts and the pivot arms (2), for dustproof and waterproof.
